Europäisches Patentamt

European Patent Office

Office européen des brevets

(19)

(11) Veröffentlichungsnummer: **0 233 594**
**A2**

(12) **EUROPÄISCHE PATENTANMELDUNG**

(21) Anmeldenummer: **87101960.0**

(22) Anmeldetag: **12.02.87**

(51) Int. Cl.⁴: **H03M 1/22**

(30) Priorität: **18.02.86 DE 3605141**

(43) Veröffentlichungstag der Anmeldung:
**26.08.87 Patentblatt 87/35**

(84) Benannte Vertragsstaaten:
**DE FR GB**

(71) Anmelder: **Messerschmitt-Bölkow-Blohm Gesellschaft mit beschränkter Haftung Robert-Koch-Strasse D-8012 Ottobrunn(DE)**

(72) Erfinder: **Kniffler, Norbert Dr. Binsberg 15 D-8011 Egmating(DE)**
Erfinder: **Legner, Wolfgang Germaniastr. 3 D-8000 München 40(DE)**

(54) **Digitaler Positionsgeber.**

(57) Beschrieben wird ein Positionsgeber, der den Auftreffort eines Licht-oder Teilchenstrahls auf einem Sensorarray erfaßt, und dessen Ausgangssignal den Auftreffort in einem digitalen Code angibt,

Der erfindungsgemäße Positionsgeber zeichnet sich dadurch aus, daß das Sensorarray aus auf einem Substrat angeordneten und mindestens teilweise miteinander sowie mit einem digitalen Bus verbundenen Dioden besteht, von denen ein Teil beim Auftreffen des Licht-bzw. Teilchenstrahls Elektron-Lochpaare erzeugt, und ein anderer entsprechend dem gewünschten Code angeordneter Teil der Dioden in seiner Funktion ausgeschaltet ist.

EP 0 233 594 A2

## Digitaler Positionsgeber

Die Erfindung bezieht sich auf einen Positionsgeber gemäß dem Oberbegriff des Patentanspruchs 1, der zur Positionsbestimmung den Auftreffort eines Licht-oder Teilchenstrahls erfaßt.

Derartige Positionsgeber sind beispielsweise als Längen-, Flächen-, Koordinaten-, Winkel-oder Geschwindigkeitsgeber verwendbar.

Da derartige Positionsgeber häufig in Geräten verwendet werden, bei denen die Weiterverarbeitung des Positionssignals digital erfolgt, ist eine Reihe von Positionsgebern entwickelt worden, bei denen die Position des Lichtstrahls in einem digitalen Code ausgegeben wird.

Positionsgeber, die die Position eines Lichtstrahls digital ausgeben und beispielsweise als Winkel-oder Längengeber verwendet werden können, sind beispielsweise aus der DE-PS 23 33 698, der DE-PS 23 35 942 oder der US-PS 4 439 672 bekannt. Bei diesen Positionsgebern wird eine Codescheibe bzw. ein Codemaßstab verwendet, der entsprechend dem gewünschten Code Bereiche aufweist, die den auftreffenden Lichtstrahl unterschiedlich beeinflussen. Diese Codescheibe bzw. dieser Codemaßstab ist gegenüber einem Lichtempfänger, der häufig noch mit einem Abtastgitter ausgestattet ist, relativbeweglich. Auf diese Weise kann die Position des auftreffenden Lichtstrahls in einem digitalen Code, beispielsweise im Binärcode, BCD-oder GRAY-Code oder einem anderen Code ausgegeben werden.

Ferner ist aus der DE-OS 32 20 560 ein photoelektrischer Codierer bekannt geworden, bei dem zwei optische Gitter relativ zueinander bewegt werden. Eines der beiden Gitter ist dabei in das Halbleitermaterial integriert, in dem auch die Lichtempfangseinrichtung ausgebildet ist.

Diese bekannten Positionsgeber sind zwar vergleichsweise kostengünstig herzustellen, sie haben jedoch den Nachteil, daß sie mechanisch bewegte Teile benötigen, die insbesondere unter rauhen Umgebungsbedingungen störanfällig sind.

Es sind deshalb verschiedene Vorschläge für Positionsgeber bekannt geworden, die den Auftreffort eines Licht-oder Teilchenstrahls absolut und digital ausgeben, und ohne bewegte Teile auskommen.

Bei einem dieser Vorschläge wird ein CCD-Array verwendet. Nachteilig bei der Verwendung von CCD-Arrays ist jedoch, daß die Ortsinformation nur seriell abrufbar ist, und daß eine vergleichsweise komplizierte Elektronik zum Auslesen der Ortsinformation erforderlich ist.

Damit ist bei derartigen Systemen nicht nur der bauliche Aufwand vergleichsweise groß; darüber hinaus genügen sie auch nicht erhöhten Geschwindigkeitsanforderungen.

Ein weiterer digitaler Positionsgeber, von dem bei der Formulierung des Oberbegriffs des Patentanspruchs 1 ausgegangen wird, ist aus der DE-OS 32 05 402 bekannt geworden. Bei diesem digitalen Positionsgeber ist eine Vielzahl von Sensoren über Operationsverstärker mit speziellen Rückkoppelungs-Anordnungen mit den Leitungen eines digitalen Busses verbunden. Durch die Rückkoppelungs-Anordnungen wird erreicht, daß das Signal auf dem digitalen Bus den Auftreffort in einem digitalen Code angibt.

Dieser digitale Längengeber ist insbesondere durch die Verwendung eines Operationsverstärkers mit einer speziellen Rückkoppelungs-Anordnung sowie eines Transistors mit mehreren Emitter-Anschlüssen für jeden Sensor sehr kompliziert, do daß er bislang in der Praxis noch nicht realisiert worden ist.

Der Erfindung liegt die Aufgabe zu Grunde, einen Positionsgeber anzugeben, der den Auftreffort eines Licht-und Teilchenstrahls **direkt in einem digitalen Code** angibt, und der vergleichsweise einfach ausgebildet und insbesondere leicht als integrierte Schaltung ausführbar ist.

Diese Aufgabe kann überraschender Weise dadurch gelöst werden, daß gemäß der Erfindung von einem Positionsgeber gemäß dem Oberbegriff des Patentanspruchs 1 ausgegangen und dieser Positionsgeber durch die im kennzeichnenden Teil des Patentanspruchs 1 angegebenen Merkmale weitergebildet wird.

Erfindungsgemäß besteht der Positionsgeber aus einer Vielzahl von Dioden, die auf einem Substrat angeordnet und mindestens teilweise miteinander sowie mit den Leitungen eines digitalen Busses verbunden sind. Von diesen Dioden erzeugt nur ein Teil beim Auftreffen des Licht-bzw. Teilchenstrahls Elektron-Lochpaare, während ein anderer Teil entsprechend dem gewünschten Code für die Ausgabe des Auftrefforts in seiner Funktion ausgeschaltet ist. Die Anordnung des in seiner Funktion ausgeschalteten Teils der Dioden hängt dabei von dem gewünschten Code ab. Die Ausgabe des Auftrefforts kann dabei direkt beispielsweise binär codiert oder im GRAY-Code erfolgen.

Der erfindungsgemäße Postionsgeber ist -da er nur aus Dioden besteht -einfach herstellbar und eignet sich insbesondere zur Herstellung mit bekannten Verfahren der Halbleitertechnologie, mit denen Dioden hoher Packungsdichte in bzw. auf einem Substrat hergestellt werden können.

Besonders vorteilhaft ist jedoch die Herstellung der Dioden aud amorphem Silizium auf einem Glas-oder Metallsubstrat mit TCO-Streifen - (Ansprüche 5 bzw. 7). Hierdurch können auch großflächige Sensorarrays kostengünstig hergestellt werden. Da das Auslesen des Auftrefforts des Strahls parallel über einen Bus erfolgt, ohne daß eine Ausleseelektronik erforderlich wäre, ist der erfindungsgemäße Positionsgeber auch in geschwindigkeitskritischen Systemen, wie beispielsweise Ziel-Suchgeräten oder Wegsensoren für Roboter-Anwendungen einsetzbar.

In jedem Falle ist es jedoch vorteilhaft, wenn gemäß Anspruch 2 ein Teil der Dioden mit einer Triggerleitung verbunden ist: je nach Ausführung kann durch ein Signal bzw. einem Impuls auf der Triggerleitung angegeben werden, ob überhaupt ein Teilchenstrahl vorhanden ist, oder ob der Teilchenstrahl seine Position geändert hat.

In den Ansprüchen 3 bis 5 bzw. 6 und 7 sind erfdindungsgemäße Weiterbildungen des Positionsgebers nach Anspruch 1 gekennzeichnet:

Der Positionsgeber nach Anspruch 3 ist insbesondere zum Erfassen des Auftrefforts eines Strahls mit länglichem Querschnitt geeignet. Hierzu sind die Dioden in den einzelnen Arrayzeilen parallel geschaltet und entsprechend dem gewünschten Code strahlungsunempfindlich bzw. -em pfindlich ausgebildet. Die Arrayzeilen stehen dabei senkrecht auf der "langen Querschnittsachse" des auftreffenden Strahls. Die Zahl der Arrayzeilen entspricht der Zahl der "Bits", d. h. der gewünschten Auflösung der digitalen Ausgabe des Auftrefforts.

Das Muster, in dem die strahlungsempfindlichen bzw. unempfindlichen Dioden angeordnet sind, kann dabei so beschaffen sein, daß die Ausgabe des Auftrefforts beispielsweise binär codiert oder im GRAY-Code erfolgt.

Die strahlempfindliche bzw. unempfindliche Ausbildung der einzelnen Dioden kann beispielsweise durch Zerstören einzelner Dioden oder selektives Abdecken der Dioden gegen die einfallende Strahlung erfolgen.

Eine besonders einfache Ausbildung des Positionsgebers gemäß Anspruch 3 erhält man nach Anspruch 4 dadurch, daß die einzelnen Arrayzeilen von jeweils einer Streifendiode gebildet werden, die selektiv strahlungsempfindlich bzw. unempfindlich durch eine entsprechende Abdeckung ausgebildet ist.

Eine derartige Streifendiode kann in besonders einfacher Weise durch Auftragen von amorphen Silicium auf einem Glas-oder Metallsubstrat erfolgen.

Die in den Ansprüchen 6 ff. gekennzeichnete Ausbildung des erfindungsgemäßen Positionsgebers eignet sich insbesondere zum Erfassen von Licht-oder Teilchenstrahls mit "punktförmigen" Querschnit, d. h. mit einer Querschnitsfläche die gleich oder kleiner als die strahlungempfindliche Fläche der einzelnen Dioden ist. Die strahlungsempfindlichen Dioden bei dieser Ausführungsform sind mit den ein zelnen Leitungen eines digitalen Busses jeweils über entgegengesetzt in Serie geschaltete Dioden verbunden. Durch selektives Aussschalten der Funktion dieser die Verbindung herstellenden Dioden erhält man auf dem Bus ein Signal entsprechend dem gewünschten Code.

Diese Ausführungsform eignet sich sowohl zur Herstellung von zeilen-oder matrixförmigen Sensoren. Auch von dieser Auführungsform können große Sensorarrays kostengünstig in Dünnfilmtechnik hergestellt werden.

Die Erfindung wird nachstehend anhand von Ausführungsbeispielen unter Bezugnahme auf die Zeichnung näher beschrieben, in der zeigen:

Fig. 1 eine Aufsicht auf ein erstes Ausführungsbeispiel der Erfindung,

Fig. 2 das Prinzipschaltbild eines zweiten Ausführungsbeispiels der Erfindung als eindimensionale Sensorzeile,

Fig. 3 einen Querschnitt durch eine Realisierung des in Fig. 2 gezeigten Ausführungsbeispiels,

Fig. 4 ein Prinzipschaltbild des zweiten Ausführungsbeispiels der Erfindung als zweidimensionsales Sensorarray,

Fig. 5 eine Anwendungsmöglichkeit des erfindungsgemäßen Positionsgebers.

Fig. 6 ein Prinzipschaltbild eines dritten Ausführungsbeispiels,

Fig. 7 als Anwendungsmöglichkeit der Erfindung eine Tastatur, und

Fig. 8 ein Prinzipschaltbild der in Fig. 7 gezeigten Tastatur.

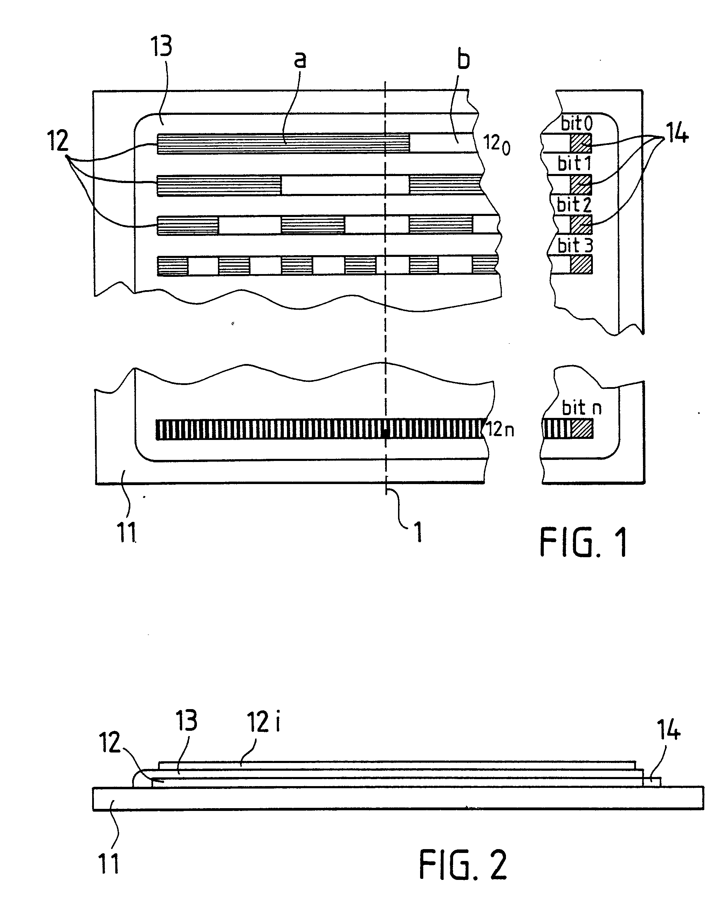

Die Fig. 1 und 2 zeigen eine Aufsicht bzw. einen Querschnitt durch ein erstes Ausführungsbeispiel der Erfindung, das zum Erfassen der Position eines (nur schematisch dargestellten) streifenförmigen Lichtbalkens (1) geeignet ist. Auf einem aus Glas bestehenden Substrat (11), durch das der Lichtbalken (1) einfällt, ist TCO - (transparent contacting oxide) aufgetragen. Die Zahl der TCO-Streifen (12) entspricht der gewünschten Auflösung "in Bit". Auf dem Substrat (11) bzw. den TCO-Streifen (12) ist eine amorphe Siliciumschicht (13) ( $\alpha$ -Silicium) aufgebracht. Die $\alpha$ -Silicium-Schicht (13) wird durch TCO-Streifen - $(12_0...12_n)$ streifenförmig kontaktiert, so daß sich streifenförmige Photodioden ergeben. Die Kontaktierung auf der Oberseite der Siliciumschicht (13) ist jedoch so ausgebildet, daß die gebildeten Streifendioden zum Teil lichtempfindlich und zum Teil nicht lichtempfindlich sind. Dies kann beispielsweise dadurch erreicht werden, daß unter einem Teil der Streifen eine Isolationsschicht, beispielsweise aus Siliciumnitrit aufgebracht wird, oder daß die nicht funktionierenden Streifenbereiche durch Lichtdegradation mit Masken hergestellt werden, oder das Licht durch einen Metallbelag abgeschirmt wird. Der oberste Zellstreifen $(12_0)$, der "das Bit 0" darstellt, ist je zur Hälfte in einen funktionierenden Streifenbereich (Bereich a) und einen nicht funktionierenden Streifenbereich - (Bereich b) unterteilt. Entsprechend ist der zweite Streifen, der das "Bit 1" darstellt, in zwei funktionierende und zwei nicht funktionierende Streifenbereiche unterteilt, usw.. Greift man nun am Ende der Streifen an Kontakten (14) den Photostrom ab, so erhält man je nach Position des Lichtbalkens (1) ein Signal oder kein Signal. Durch die gewählte Unterteilung in funktionierende und nicht funktionierende Striefenbereiche erhält man an den Kontakten (14) die Position des Lichtbalkens (1) in binär kodierter Form.

Würde man die Unterteilung in funktionierende und nicht funktionierende (lichtempfindliche bzw. lichtunempfindliche) Bereiche in anderer Form vornehmen, so würde die Position an den Metallkontakten (14) in einem anderen Code, beispielsweise im "Gray-Code" ausgegeben. Durch entsprechende Einteilung der streifenförmigen Photodioden in funktionierende und nicht funktionierende Bereiche lassen sich auch Verschlüsselungen etc. realisieren.

In jedem Falle erhält man einen Positionsgeber, der den Auftreffort eines streifenförmigen Licht-oder Teilchenstrahls in einem digitalen Code angibt, ohne daß zusätzliche Schaltungsmaßnahmen oder Maßnahmen zum Auslesen der Signale erforderlich wären. Das in den Fig. 1 und 2 dargestellte Ausführungsbeispiel eignet sich nicht nur zur Erfassung der eindimensionalen Position eines Licht-oder Teilchenstrahls in einer Ebene, vielmehr kann auch in einfacher Weise ein Winkelmesser realisiert werden, Hierzu werden die parallelen in funktionierende und nicht funktionierende Bereiche unterteilten "Streifendioden" auf einen "Zylinder" aufgebracht. Dabei kann es von Vorteil sein, wenn der Lichtstrahl nicht durch das Substrat, sondern durch die auf der Oberseite der Siliciumschicht (12) aufgebrachten Streifen einfällt, die dann beispielsweise als TCO-Streifen mit teilweiser lichtundurchlässiger Abdeckung ausgeführt sein können. Das Substrat kann -wenn das Licht durch die Streifen (13) einfällt, auch als Metallsubstrat, beispielsweise als V2A-Substrat ausgebildet sein.

Das in den Fig. 1 und 2 dargestellte erste Ausführungsbeispiel hat zwar den Vorteil, daß sein Ausgangssignal den Auftreffort eines Licht-oder Teilchenstrahls ohne weitere Schaltungsmaßnahmen in einem digitalen Code angibt; es hat aber den Nachteil, daß der Licht-und/oder Teilchenstrahl einen länglichen und insbesondere einen streifenförmigen Querschnitt haben muß.

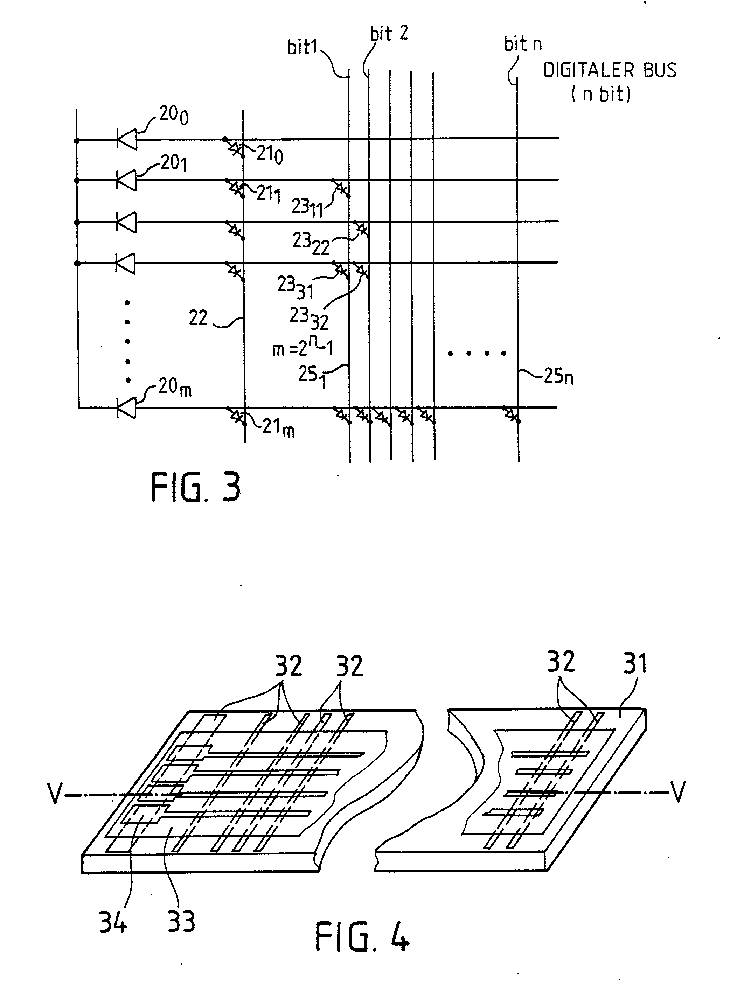

Die Fig. 3 bis 5 zeigen ein zweites Ausführungsbeispiel der Erfindung, das die Position eines (idealisiert) punktförmigen Licht-oder Teilchenstrahls auf einer Sensorzeile erfaßt und in einem nahezu frei wählbaren digitalen Code ausgibt.

Fig. 3 zeigt ein Blockschaltbild der Erfindung. Bei diesem Ausführungsbeispiel sind $m+1$ Photodioden $(20_0$ bis $20_m)$ zeilenförmig angeordnet. Jede Photodiode (20) ist über eine entgegengesetzt in Serie geschaltete Photodiode $(21_0$ bis $21_m)$ mit einer Triggerleitung (22) verbunden. Ein Signal auf der Triggerleitung (22) zeigt an, daß auf einer der Photodioden (20) ein Licht-oder Teilchenstrahl auftrifft. Ferner sind die einzelnen Photodioden $(20_0$ bis $20_n)$ über entgegengesetzt in Serie geschaltete Photodioden $(23_{11}, 23_{22}, 23_{31}, 23_{32}$ usw.) mit den n-Leitungen $(25_1 ... 25_n)$ eines n-Bit breiten digitalen Busses verbunden.

Der Positionsgeber, dessen Prinzipschaltbild in Fig. 3 dargestellt ist, kann sowohl als photoelektrisches Element als auch mit angelegter Sperrspannung betrieben werden. Die Betriebsart als photoelektrisches Element (oder auch eine Serienschaltung von photoelektrischen Elementen = Modul) erhält man dadurch, daß man die Photodioden (20) kathodenseitig auf Bezugspotential legt; die an der Anode anstehende photoelektrische Spannung, die durch den auftreffenden "Lichtpunkt" erzeugt wird, wird über die die Dioden (23) entsprechend dem durch die Beschaltung eingestellten digitalen Code an den Bus weitergeleitet.

Die andere Betriebsart erhält man dadurch, daß man die Photodioden (20) kathodenseitig auf positives Potential legt. Durch die Beleuchtung einer Photodiode entsteht ein Photostrom in Sperrichtung, der ebenfalls durch die Dioden (23) an den digitalen Bus weitergegeben wird.

Durch die Anordnung der den Photostrom bzw. die photoelektrische Spannung an den digitalen Bus weiterleitenden Dioden (23) kann der gewünschte digitale Code ausgewählt werden. In Fig. 3 ist eine Anordnung gezeigt, die zu einer binären Kodierung der Position des Lichtpunkts führt.

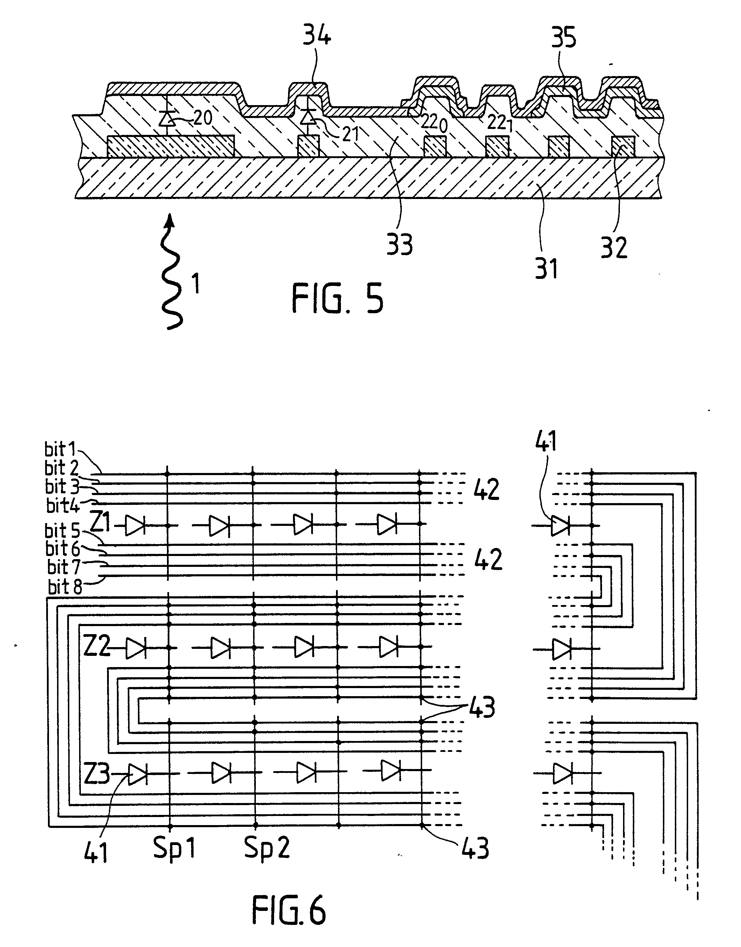

Die Fig. 4 und 5 zeigen eine praktische Realisierung des in Fig. 2 im Prinzipschaltbild gezeigten zweiten Ausführungsbeispiels, und zwar zeigt Fig. 4 eine Aufsicht und Fig. 5 einen Schnitt bei der Linie V-V in Fig. 4.

Auf einem Glassubstrat (31), durch das der "punktförmige" Lichtstrahl (1) einfällt, sind in gleicher Weise wie bei dem in den Fig. 1 und 2 dargestellten ersten Ausführungsbeispiel TCO-Streifen (32) aufgebracht, die die Photodioden (20), die Dioden (21) sowie die Dioden (23) definieren. Auf den Glassubstrat (31) bzw. den TCO-Streifen (32) ist wiederum amorphes Silicium (33) aufgebracht. Auf der Oberseite der amorphen Siliciumschicht (33) sind Metallisierungs-Streifen (34) senkrecht zu den TCO-Streifen (32) aufgebracht. Da -wie Fig. 3 zeigt -verschiedene Photodioden nicht mit verschiedenen Busleitungen verbunden sein sollen, sind diejenigen Dioden-Matrixpunkte, die keine Verbindung erzeugen sollten, also immer den logischen Wert "0" haben sollen, durch eine beispielsweise aus Siliciumnitrit bestehende Isolierschicht (35) abgedeckt. Damit erhält man mit einer regelmäßigen und einfach herzustel lenden Diodenstruktur das in Fig. 3 dargestellte Prinzipschaltbild durch das ein Positionsgeber realisiert wird, der den Auftreffort eines "punktförmigen" Lichtstrahls in einem digitalen Code ausgibt. Dieser Code kann dadurch gewählt werden, daß bestimmte Dioden, die die Photodioden mit den digitalen Bus verbinden, in ihrer Funktion ausgeschaltet sind.

Fig. 6 zeigt ein Prinzipschaltbild eines dritten Ausführungsbeispiels. Dieses Ausführungsbeispiel stellt eine Abwandlung des zweiten Ausführungsbeispiels dar und ermöglicht die zweidimensionale Erfassung der Position eines Licht- oder Teilchenstrahls.

Matrixförmig angeordnete Photodioden (41) sind mit den Leitungen eines n-Bit breiten Busses (42) über entgegengesetzt in Serie geschaltete Photodioden (43) verbunden, die in Fig. 6 durch Punkte symbolisiert sind. Wie bei dem zweiten Ausführungsbeispiel wird die entstehende Photospannung bzw. der Photostrom von der Photodiode an den Bus über die entsprechende Matrixdiode weitergegeben.

Bei dem in Fig. 6 dargestellten Ausführungsbeispiel wird ein 8 bit breiter Bus verwendet, wobei Bit 1 als Trigger verwendet wird. Die Bit 2 -8 werden zur Zeilen-bzw. Spaltenkodierung benutzt, wobei Bit 2 -6 die Spaltennummer (0 bis 31) und Bit 7 -8 die Zeilennummer darstellt.

Auch dieses Ausführungsbeispiel kann mit einer Dünnfilmschaltung gemäß den Fig. 4 und 5 realisiert werden, so daß auf eine eingehende Beschreibung verzichtet werden kann.

Die in Verbindung mit den Fig. 1 bis 6 erläuterten erfindungsgemäßen Positionsgeber haben eine Vielzahl von Anwen dungsmöglichkeiten. Beispielsweise können sie als Wegsensoren für Handhabungsautomaten, als Aufnehmer für Kompensationsschreiber oder X/Y-Kreuztische sowie für Ziel-Suchgeräte verwendet werden. Natürlich können sie auch in allen Anwendungsfällen eingesetzt werden, in denen Längen- oder Winkelgeber eingesetzt werden, die ein analoges Ausgangssignal liefern.

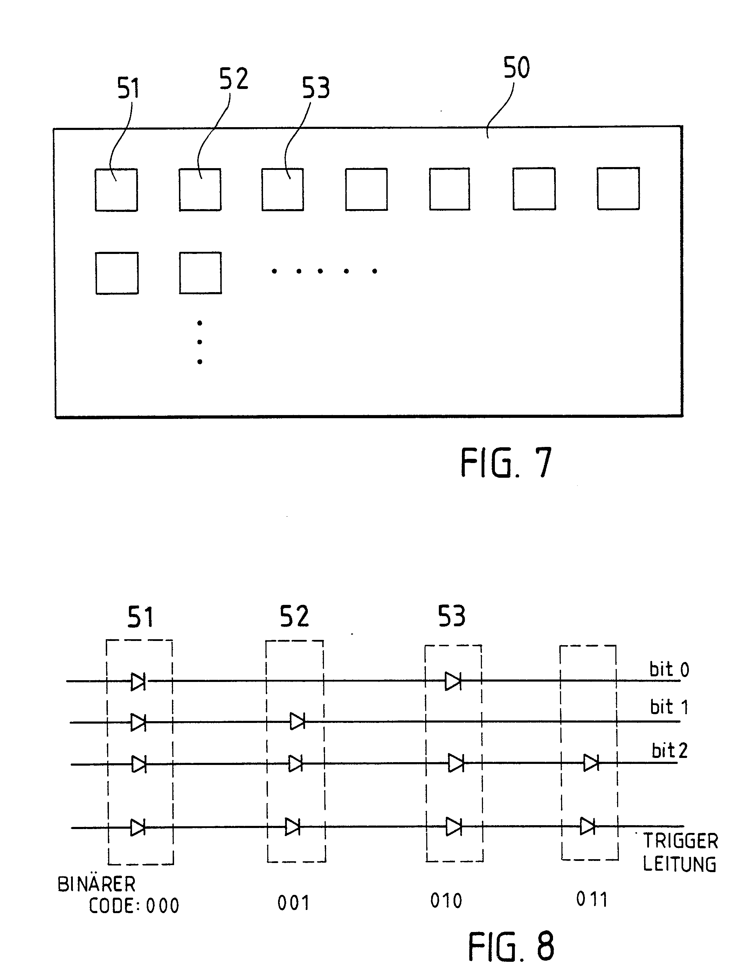

Fig. 7 zeigt als möglichen Anwendungsfall eines erfindungsgemäßen Positionsgebers eine Tastatur. Die äußere Tastatur ist eine Glasscheibe 50, die mit einer $SnO_2$-Schicht versehen ist. Auf der $SnO_2$-Schicht sind strukturierte α -Silicium-Sensoren 51, 52, 53... aufgebracht, die die digitale Ausgangssignal-Aufbereitung bewerkstelligen. Weil die aktiven Strukturen hinter der Glasscheibe durch Lasersegmentieren hergestellt werden können, ist auch eine griffgünstige Tastenanordnung denkbar. Die Glasscheibe ist auch ein hervorragender Schutz der Tastatur gegen Staub, Nässe, Säuren und mechanischen Verschleiß.

Fig. 8 dient zur Erläuterung des elektronischen Arbeitsprinzips. Im Grundzustand werden alle Sensoren beleuchtet. D.h., daß an allen Ausgängen eine logische "1" erscheint. "Drückt" man beispielsweise auf die Taste 51, so werden alle 3 Serienschaltungen unterbrochen und alle Ausgänge liegen auf dem Wert "0". Wird z.B: die Taste 53 betätigt, so gehen nur Bit 0 und Bit 2 auf "0", da in der Bit 1-Leitung keine Diode sitzt.

Eine Triggerleitung ist auf einfachste Weise zu erhalten, indem eine Sensorreihenschaltung durch alle Tasten gezogen wird.

Die Strukturierung der Tastensensoren kann mit den selben Methoden, wie sie bei der Herstellung von α-Silicium-Dünnfilmschaltungen angewendet werden, also z.B. durch Laserstrukturierung, oder photolithographisch erfolgen.

Eine Anwendung ist also eine Kleintastatur, die einen direkten digitalen Code liefert.

Eine weitere Anwendung besteht in der Verwendung von Lichtschranken, die einen digitalen Code absenden, wodurch auf einer einzigen Busleitung die Identifizierung des Sensors durch den Rechner nahezu ohne Aufwand erfolgt.

Die Sensoren können von Stromversorgungen unabhängig gemacht werden, da ein "Solarmodul" integrierbar ist.

Vorstehend ist die Erfindung anhand von Ausführungsbeispielen ohne Beschränkung der Allgemeinheit beschrieben worden. Innerhalb des allgemeinen Erfindungsgedankens, einen Positionsgeber, der den Auftreffort eines Licht-oder Teilchenstrahls in einem digitalen Code direkt angibt, dadurch zu realisieren, daß ein Sensoraray verwendet wird, das aus mindestens teilweise miteinander sowie mit einem digitalen Bus verbundenen Dioden Besteht -sind natürlich die verschiedenstens Modifikationen möglich:

Beispielsweise sind vorstehend nur Realisierungen in sog. Dünnfilmtechnik beschrieben worden. Natürlich können die Diodenanordnungen auch mit anderen Herstellverfahren realisiert werden, beispielsweise können anstelle von PIN-Strukturen PN-Strukturen oder Schottky-Übergänge verwendet werden. Das Ausschalten einzelner Dioden, die keine Verbindungen zwischen den Sensordioden und dem digitalen Bus herstellen sollen, kann auf die verschiedenste Weise erfolgen.

Ferner kann bei der Realisierung der verschiedenen Matrixdioden in Dünnfilmtechnik das Substrat nicht nur aus Glas mit aufgebrachten TCO-Streifen bestehen, sondern auch aus einem Metall. Die TCO-Streifen können dann auf der Oberseite der Siliciumschicht vorgesehen werden, durch die dann der Licht-oder Teilchenstrahl einfällt.

Die TCO-Streifen können mit den verschiedensten Herstellarten, beispielsweise durch Ätzen oder Lasersegmentieren oder auch durch den bekannten TCO-Herstellungsprozess aufgebracht werden.

## Ansprüche

1. Positionsgeber, der den Auftreffort eines Licht-oder Teilchenstrahls auf einem Sensorarray erfaßt, und dessen Ausgangssignal den Auftreffort in einem digitalen Code angibt,
dadurch **gekennzeichnet,** daß das Sensorarray aus auf einem Substrat angeordneten und mindestens teilweise miteinander sowie mit einem digitalen Bus verbundenen Dioden besteht, von denen ein Teil beim Auftreffen des Licht-bzw. Teilchenstrahls Elektron-Lochpaare erzeugt, und ein anderer entsprechend dem gewünschten Code angeordneter Teil der Dioden in seiner Funktion ausgeschaltet ist.

2. Positionsgeber nach Anspruch 1,
dadurch **gekennzeichnet,** daß die Dioden regulär und insbesondere in Matrixform angeordnet sind.

3. Positionsgeber nach Anspruch 1 oder 2,
dadurch **gekennzeichnet,** daß ein weiterer Teil der Dioden mit einer Triggerleitung verbunden ist.

4. Positionsgeber nach einem der Ansprüche 1 bis 3,
dadurch **gekennzeichnet,** daß zum Erfassen des Auftrefforts eines Strahls mit länglichem Querschnitt die Dioden der einzelnen Arrayzeilen parallel geschaltet und entsprechend dem gewünschten Code strahlungsunempfindlich bzw. -empfindlich ausgebildet sind.

5. Positionsgeber nach Anspruch 4,
dadurch **gekennzeichnet,** daß jeweils eine Streifendiode die einzelnen Arrayzeilen bildet, die selektiv gegen die einfallende Strahlung abgedeckt ist.

6. Positionsgeber nach Anspruch 5,
dadurch **gekennzeichnet,** daß die Streifendiode durch Auftragen von amorphem Silicium auf einem Glas-oder Metallsubstrat mit TCO-Streifen hergestellt ist.

7. Positionsgeber nach einem der Ansprüche 1 bis 3,
dadurch **gekennzeichnet,** daß die strahlungsempfindlichen Dioden mit den einzelnen Leitungen eines digitalen Busses jeweils über eine entgegengesetzt in Serie geschaltete Diode verbunden sind, die selektiv entsprechend dem gewünschten Code ausgeschaltet sind.

8. Positionsgeber nach Anspruch 7,
dadurch **gekennzeichnet,** daß die einzelnen Dioden durch Aufbringen von amorphem Silicium auf ein Glassubstrat mit TCO-Streifen und entsprechende Isolierung bzw. Kontaktierung auf der Gegenseite hergestellt sind.

FIG. 1

FIG. 2

9915

FIG. 3

FIG. 4

9915

FIG. 5

FIG.6

9915

FIG. 7

FIG. 8

BINÄRER
CODE: 000          001          010          011

bit 0
bit 1
bit 2
TRIGGER
LEITUNG

9915